# EUROPEAN PATENT APPLICATION

(11) **EP 4 654 783 A1**
(43) Date of publication of application: **26.11.2025**
(21) Application number: 25177587.0
(22) Date of filing: 20.05.2025
(51) Int. Cl.: H10D 84/01, H10D 30/01, H10D 30/00, H10D 84/83

(54) **INTEGRATION OF THICK I/O OXIDE FOR NANOSHEET GATE-ALL-AROUND DEVICES**

(30) Priority: 24.05.2024 US 202418674334
(71) Applicant: NXP USA, Inc., Austin, TX 78735 (US)
(72) Inventor: Hall, Mark Douglas, 5656AG Eindhoven (NL); Dinh, Viet Thanh, 5656AG Eindhoven (NL); Perera, Asanga H, 5656AG Eindhoven (NL)
(74) Representative: Miles, John Richard

(57) **Abstract**

A semiconductor device and fabrication method are described for integrating I/O and core nanosheet transistors in a single nanosheet process flow by processing a stack of alternating first and second semiconductor structures formed on a substrate, where the first semiconductor structures located over a I/O thick oxide transistor region include a planar semiconductor channel layer sandwiched between upper and lower dielectric layers, and where the alternating first and second semiconductor structures are processed to form gate-all-around electrodes in a core transistor stack that are connected over a relatively thinner gate dielectric layer to control one or more first planar semiconductor channel layers in the core transistor stack, and to form gate-all-around electrodes in an I/O transistor stack that are connected over a relatively thicker gate dielectric layer to control one or more second planar semiconductor channel layers in the I/O transistor stack.

## Description

### BACKGROUND OF THE INVENTION

### Field of the Invention

The present disclosure is directed in general to the field of semiconductor devices. In one aspect, the present invention relates to integrated nanosheet devices and methods of fabricating same in a nanosheet process flow.

### Description of the Related Art

As semiconductor device sizes are scaled down, the requirements for device design and fabrication continue to be tightened in order to fit more circuitry on smaller chips. As device sizes shrink, increasingly complex process integrations are used to define semiconductor device features and structures. For example, finFET transistors replaced planar FET transistors as the leading-edge transistor architecture for 20 nm nodes or less, but with next-generation technologies, stacked nanosheet transistors are in line to replace finFETs as the leading-edge transistor architecture starting at the 3 nm node. However, the limited space between stacked nanosheets makes it very difficult to integrate the thick oxide needed for handling larger I/O voltages at input/output (I/O) devices or for critical analog circuits requiring higher voltages (e.g., power amplifiers) without sacrificing performance and design efficiencies. For example, thicker oxide requirements for gate-all-around stacked nanosheet devices do not allow sufficient space for gate-all-around metal electrode layers, or require that the number of stacked nanosheet layers in I/O devices is smaller than the number of stacked nanosheet layers in core devices, or require non-planar I/O and core stacks, or are fabricated with non-uniform or curved silicon nanosheet channels which undercut the inner spacers. As a result, leading edge foundries may not offer thick oxide I/O devices, but may instead support I/O voltages by cascoding or stacking thin oxide core devices, thereby increasing die area and cost while decreasing performance. As seen from the foregoing, the existing solutions for integrating the fabrication of I/O and core nanosheet field effect transistor (FET) devices have significant disadvantages by virtue of the challenges with fabricating leading edge nanosheet transistors while meeting the performance requirements and cost constraints. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.

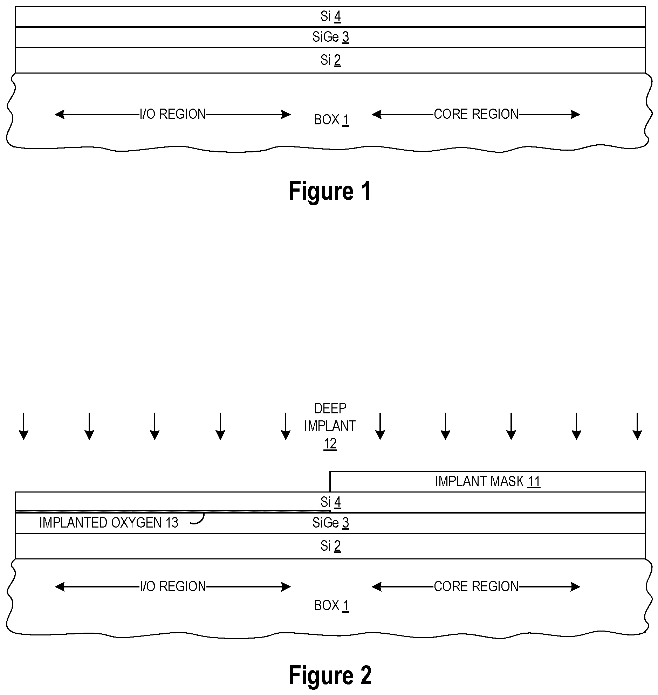

Figures 1-12 illustrate cross-sectional views at different stages of manufacture of a semiconductor structure having core nanosheet transistors integrated with I/O nanosheet transistors fabricated with selectively implanted and annealed oxygen to form thicker gate oxides in accordance with selected first embodiments of the present disclosure.

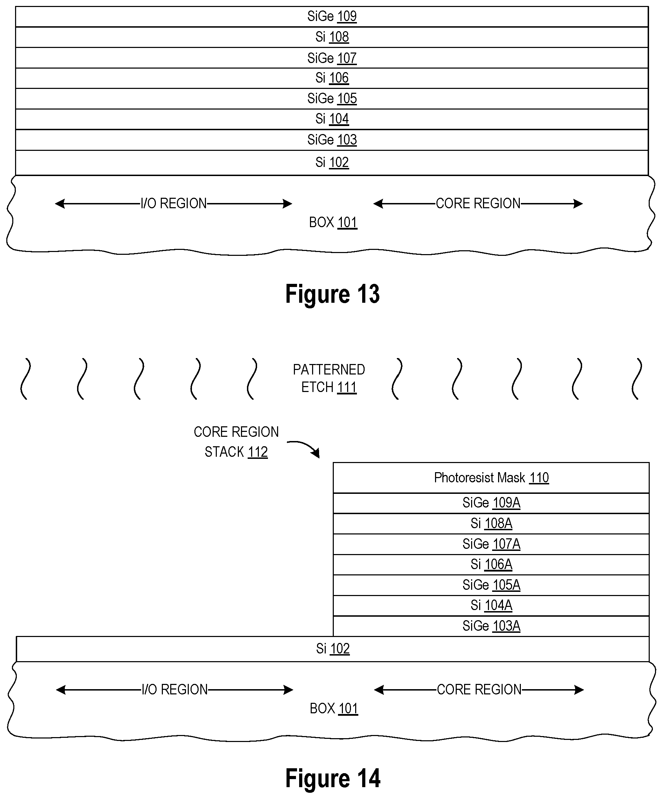

Figures 13-19 illustrate cross-sectional views at different stages of manufacture of a semiconductor structure having core nanosheet transistors integrated with I/O nanosheet transistors fabricated with atomic layer deposition oxide layers to form thicker gate oxides in accordance with selected second embodiments of the present disclosure.

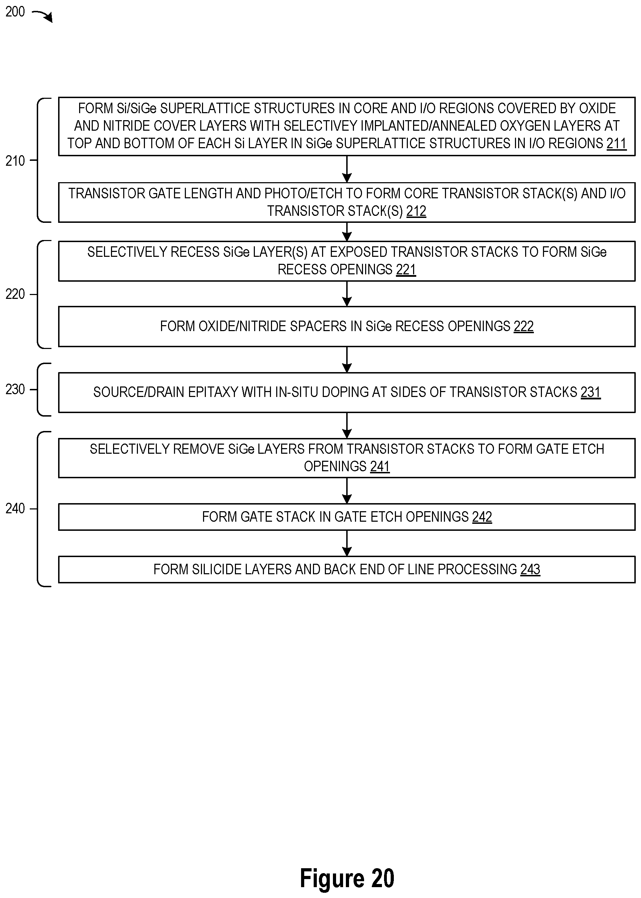

Figure 20 illustrates a simplified process flow for integrating the fabrication of core nanosheet transistors with I/O nanosheet transistors having thicker gate oxides in accordance with selected embodiments of the present disclosure.

### DETAILED DESCRIPTION

A nanosheet stack transistor device and method are described for integrating the fabrication of nanosheet core transistors having thinner gate oxides with nanosheet input/output (I/O) transistors having thicker gate oxides in a single nanosheet process flow, thereby providing a straightforward method for integrating core and I/O nanosheet stack transistors on the same die with additional fabrication processing steps that are designed to have minimal effect on the nanosheet transistors. In selected embodiments, some process steps used for fabricating the core and I/O nanosheet transistors are non-standard process steps, so new fab tools or materials may be needed. In selected embodiments, an initial set of fabrication steps form a Si/SiGe superlattice structure on a wafer substrate with alternating silicon germanium nanosheets and silicon nanosheets, where each silicon nanosheet located over an I/O region is selectively implanted with deep and shallow oxygen implants while each silicon nanosheet located over a core region is protected from oxygen implantation by an implant mask. After annealing the Si/SiGe superlattice structure, the oxygen implants are restructured with an oxide self-assembly effect to form oxide layers at the top and bottom of each silicon nanosheet. In other selected embodiments, an initial set of fabrication steps form a Si/SiGe superlattice structure for I/O nanosheet stack transistors on a wafer substrate by sequentially depositing atomic layer deposition (ALD) oxide, electron-enhanced ALD silicon, and electron-enhanced ALD silicon germanium to form alternating silicon germanium nanosheets and silicon nanosheets separated by ALD oxide layers. However formed, the Si/SiGe superlattice structure is patterned and etched to form separate I/O transistor stacks, alone or in combination with core transistor stacks. With a first set of fabrication steps, the I/O and core transistor stacks are processed to partially etch exposed SiGe nanosheets and form SiGe recess openings in the I/O and core transistor stacks which are filled with inner nitride spacers to define remnant SiGe layers. With a second set of fabrication steps, epitaxial source/drain regions are formed on the sides of the I/O and core transistor stacks. With a third set of fabrication steps, the I/O and core transistor stacks are processed to remove remnant SiGe layers and to form SiGe gate etch openings which are filled with atomic layer deposition (ALD) oxide and metal layers to form a first set of transistor gate electrodes with thicker gate oxides in the I/O transistor stack and to simultaneously form a second set of transistor gate electrodes with thinner gate oxides in the core transistor stack.

Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process technology or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. For example, the dimensions of some of the elements in the figures may be exaggerated relative to other elements to help improve the understanding of the embodiments of the present invention. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

Various illustrative embodiments of the present invention will now be described in detail with reference to Figures 1-19. It is noted that, throughout this detailed description, certain layers of materials will be deposited and removed to form the semiconductor structure. Where the specific procedures for processing such layers or thicknesses of such layers are not detailed below, conventional techniques to one skilled in the art for depositing, removing or otherwise forming such layers at appropriate thicknesses shall be intended. Such details are well known and not considered necessary to teach one skilled in the art how to make or use the present invention.

Turning now to Figure 1, a partial cross-sectional view illustrates a semiconductor structure including the initial Si/SiGe superlattice layers 2-4 which are formed over a buried oxide (BOX) or dielectric layer 1 in accordance with selected embodiments of the present disclosure. Though not shown, it will be appreciated that the semiconductor structure 1-4 is formed over an underlying substrate which may be implemented as a bulk silicon substrate, monocrystalline silicon (doped or undoped), or any semiconductor material including, for example, Si, SiC, SiGe, SiGeC, Ge, GaAs, InAs, InP as well as other Group III-V compound semiconductors or any combination thereof, and may be formed as the bulk handling wafer.

As will be appreciated, any suitable sequence of processing steps may be used to form the initial Si/SiGe superlattice layers 2-4 on the base structure BOX layer 1, such as by epitaxially growing a plurality of nanosheet semiconductor layers of alternating silicon (Si) nanosheets 2, 4 and silicon germanium (SiGe) nanosheets 3 which cover both the I/O and core regions. The relative thicknesses and material components of the initial Si/SiGe superlattice layers 2-4 can be controlled as desired to achieve the core and I/O nanosheet transistors described hereinbelow. For example, each SiGe nanosheet layer (e.g., 3) may be formed with a predetermined thickness and material to allow for selective removal using an etch chemistry that is targeted to remove the SiGe layer and form a gate electrode opening that is sized to allow formation of an ALD gate dielectric layer and ALD metal gate electrode in the gate electrode opening. In addition, each Si nanosheet layer (e.g., 2, 4) may be formed with a predetermined thickness and material to allow for selective implantation and annealing of oxygen to form oxide layers in the top and bottom of each Si nanosheet layer that are positioned to form I/O oxides with the ALD gate dielectric layers while maintaining uniform or flat silicon gate-all-around channels.

As disclosed herein, the Si nanosheet layer 2, SiGe nanosheet layer 3, and Si nanosheet layer 4 are sequentially formed or grown over the semiconductor structure using any suitable deposition or growth process, including but not limited to epitaxial growth/deposition/formation, chemical vapor deposition (CVD), plasma-enhanced chemical vapor deposition (PECVD), physical vapor deposition (PVD), molecular beam epitaxy, sputtering, atomic layer deposition (ALD), electron-enhanced ALD (EE-ALD) or the like. The terms "epitaxial growth, "epitaxial deposition" and "epitaxial formation" all refer generally to a semiconductor process for growing a semiconductor material or layer having a (substantially) crystalline structure on a deposition surface of seed semiconductor material or layer having a (substantially) crystalline structure such that the semiconductor material/layer being grown has substantially the same crystalline characteristics as the seed semiconductor material/layer. In an epitaxial deposition process, the chemical reactants provided by the source gases are controlled, and the system parameters are set so that the depositing atoms arrive at the deposition surface of the semiconductor substrate with sufficient energy to move about on the surface such that the depositing atoms orient themselves to the crystal arrangement of the atoms of the deposition surface. Therefore, an epitaxially grown semiconductor material has substantially the same crystalline characteristics as the deposition surface on which the epitaxially grown material is formed. If desired, the individual layers 2-4 of the Si/SiGe superlattice stack may be doped or implanted with impurities to control the conductivity of the individual layers 2-4.

Figure 2 illustrates processing of the semiconductor structure subsequent to Figure 1 after selectively implanting a deep implanted oxygen layer 13 in the Si nanosheet layer 4 by performing a deep oxygen implantation process 12 through openings in the patterned implant mask 11. As a preliminary step in the selective implantation process, the patterned implant mask 11 may be formed over the initial Si/SiGe superlattice layers 2-4 by depositing or coating the semiconductor structure with a photoresist layer that is subsequently developed and exposed to transfer a pattern from a mask to the semiconductor structure so that the patterned implant mask 11 protects the core region and has openings defined to expose the I/O region. With the patterned implant mask 11 in place, the deep oxygen implantation process 12 is applied to form the deeply implanted oxygen layer 13 in the Si nanosheet layer 4 that is exposed by the patterned implant mask 11. As disclosed, the implantation power and dosage parameters of the deep oxygen implantation process 12 are controlled to implant oxygen at the bottom of the Si nanosheet layer 4. For example, with a Si nanosheet layer 4 that has a thickness of 70 Angstroms, the deep oxygen implantation process 12 may be configured to implant oxygen with an ion implantation energy of approximately 1.6 keV and dopant concentration in the range of about 5E17 to 1E19 atoms/cm², thereby forming the deep implanted oxygen layer 13at a target implant depth of approximately 60 Angstroms. As will be appreciated, the deep oxygen implantation process 12 may use any suitable oxygen implantation technique, including but not limited to traditional ion implantation and plasma-immersion ion implantation (PIII) for implanting a deep implanted oxygen layer 13 in the Si nanosheet layer 4. One of the advantages of PIII processing is its flexibility in being able to control the range of ion implantation energy (from a few eV to about 100 keV). Unless accompanied by a high temperature anneal process, the deep oxygen implantation process 12 will create structural disruptions in the monocrystalline Si nanosheet layer 4 with a Gaussian-like distribution of oxygen in the deeply implanted oxygen layer 13.

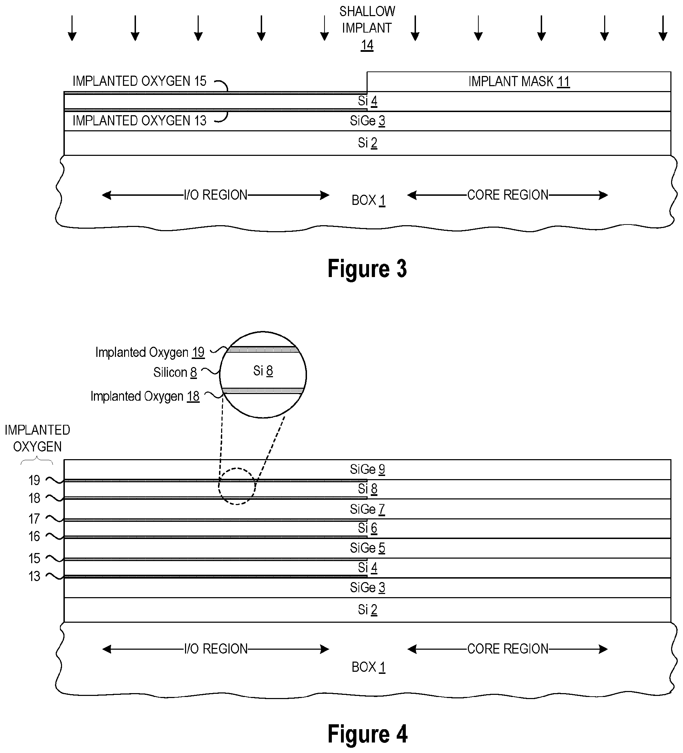

Figure 3 illustrates processing of the semiconductor structure subsequent to Figure 2 after selectively implanting a shallow implanted oxygen layer 15 in the Si nanosheet layer 4 by performing a shallow oxygen implantation process 14 through openings in the patterned implant mask 11. In particular, the shallow implantation process 14 uses the same patterned implant mask 11 to form the shallow implanted oxygen layer 15 in the Si nanosheet layer 4 that is exposed by the patterned implant mask 11 by controlling the implantation power and dosage parameters to implant oxygen at the top of the Si nanosheet layer 4. For example, with a Si nanosheet layer 4 that has a thickness of 70 Angstroms, the shallow oxygen implantation process 14 may be configured to implant oxygen with an ion implantation energy of approximately 100 eV and dopant concentration in the range of about 5E17 to 1E19 atoms/cm², thereby forming the shallow implanted oxygen layer 15 at a target implant depth of approximately 11 Angstroms. Again, the shallow oxygen implantation process 14 may use any suitable oxygen implantation technique, including but not limited to traditional ion implantation and PIII for implanting the shallow implanted oxygen layer 15 in the Si nanosheet layer 4. Unless accompanied by a high temperature anneal process, the shallow oxygen implantation process 14 will create structural disruptions in the monocrystalline Si nanosheet layer 4 with a Gaussian-like distribution of oxygen in the shallow implanted oxygen layer 15.

Figure 4 illustrates processing of the semiconductor structure subsequent to Figure 3 after completing the fabrication of the Si/SiGe superlattice layers 2-9 and implanted oxygen layers 13-19 on the base structure BOX layer 1. As will be appreciated, any suitable sequence of processing steps may be used to form the Si/SiGe superlattice layers 2-9 and implanted oxygen layers 13-19 on the base structure BOX layer 1, such as by epitaxially growing a plurality of nanosheet semiconductor layers of alternating SiGe nanosheet layers 3, 5, 7, 9 and Si nanosheet layers 2, 4, 6, 8 with each Si nanosheet layer (except the bottom Si nanosheet layer) being selectively implanted with deep and shallow oxygen layers. In an example processing sequence, the patterned implant mask 11 may be stripped from the semiconductor structure using any suitable stripping process. Subsequently, a SiGe nanosheet layer 5 and Si nanosheet layer 6 are sequentially formed or grown over the semiconductor structure using any suitable epitaxial growth process, including but not limited to epitaxial growth/deposition/formation, CVD, PECVD, PVD, molecular beam epitaxy, sputtering, ALD, EE-ALD, or the like. Subsequently, a second patterned implant mask (not shown) is formed over the Si nanosheet layer 6 which protects the Si nanosheet layer 6 over the core region and which exposes the Si nanosheet layer 6 over the I/O region. With the second patterned implant mask in place, a deep oxygen implantation process and shallow oxygen implant process are applied to form, respectively, the deeply implanted oxygen layer 16 and shallow implanted oxygen layer 17 in the Si nanosheet layer 6. In turn, the process is iteratively repeated to strip the second patterned implant mask, sequentially form or grow the SiGe nanosheet layer 7 and Si nanosheet layer 8, form third patterned implant mask (not shown) to expose the Si nanosheet layer 8 over the I/O region, and apply deep and shallow oxygen implantation processes to form the deeply implanted oxygen layer 18 and shallow implanted oxygen layer 19 in the Si nanosheet layer 8. Finally, the third patterned implant mask is stripped and the topmost SiGe nanosheet layer 9 is grown or deposited over the semiconductor structure.

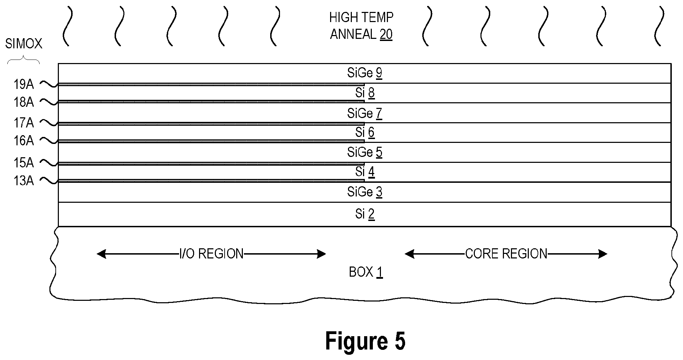

Figure 5 illustrates processing of the semiconductor structure subsequent to Figure 4 after applying a high temperature anneal step 20 to the completed Si/SiGe superlattice layers 2-9 and implanted oxygen layers 13, 15, 16-19, thereby creating SIMOX (separation by implantation of oxide) layers 13A, 15A, 16A-19A over the I/O region. Though not explicitly shown in the drawings, the high temperature anneal process 20 creates an oxide self-assembly effect whereby the implanted oxygen layers 13, 15, 16-19 are restructured within the monocrystalline structure of the Si nanosheet layers 4, 6, 8 in such a way that the Gaussian-like distribution of oxygen changes to a flat-topped distribution. Though any suitable anneal process may be used, the high temperature anneal step 20 may heat the semiconductor structure to approximately 600°C during implantation, alone or in combination with a distinct heating process whereby the semiconductor structure is heated to at least 1300°C for at least 30 minutes which effectively segregates implanted oxygen into the buried layers to form a high-quality oxide layer with a smooth oxide/silicon interface.

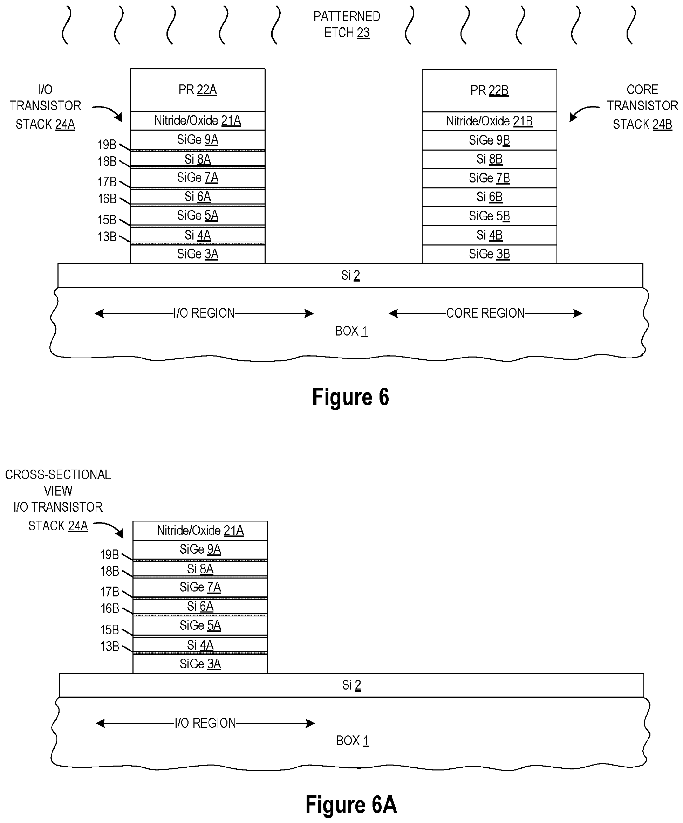

Figures 6-6A illustrate processing of the semiconductor structure subsequent to Figure 5 after a patterned etch process 23 is applied to the stacked Si/SiGe superlattice layers 2-9 and implanted and annealed oxide layers 13A, 15A, 16A-19A to form an I/O transistor stack 24A and core transistor stack 24B. In particular, Figure 6 depicts a first cross-sectional perspective of the I/O region and core region along the gate length direction, while Figure 6A depicts the I/O region from a second perpendicular cross-sectional perspective along the gate width direction. While any suitable pattern and etch process 23 may be used, a first nitride and/or oxide 21A, 21B may be formed over the topmost SiGe nanosheet layer 9, such as by depositing or otherwise forming a protective oxide layer using CVD, PECVD, PVD, ALD, thermal oxidation, or any combination(s) of the above to a thickness of approximately 20-200 Angstroms, though a thinner or thicker oxide layer may also be used. In addition or in the alternative, a protective nitride layer may be deposited or otherwise formed on the protective oxide layer to a predetermined thickness of approximately 20-200 Angstroms, though a thinner or thicker nitride layer may also be used. Though not shown, it will be appreciated that the protective oxide/nitride layer 21A, 21B is formed to completely cover the unetched stacked Si/SiGe superlattice layers 2-9 and implanted and annealed oxide layers 13A, 15A, 16A-19A, including the intended I/O and core nanosheet transistor areas. Subsequently, a patterned photoresist (PR) mask 22A, 22B may be formed over the protective oxide/nitride layer 21 by depositing, patterning, etching or developing a photoresist or hard mask layer. With the patterned photoresist mask 22A, 22B in place, one or more etch processes are applied to create an I/O transistor stack 24A (3A-9A, 13B, 15B, 16B-19B) and a core transistor stack 24B (3B-9B). The etch processing can include using the patterned photoresist mask 22A, 22B to perform a sequence of reactive-ion etching (RIE) steps having suitable etch chemistry properties to remove, in sequence, the exposed portions of the protective nitride/oxide layer(s) 21, the underlying layers of the Si/SiGe superlattice 3A-9A and annealed oxide layers 13A, 15A, 16A-19A in the I/O region, and the underlying layers of the Si/SiGe superlattice 3B-9B in the core region. As will be appreciated, the sidewalls of the core and I/O transistor stacks 24A, 24B are substantially vertical, though minor deviations in the sidewall profile may occur at each layer due to etch processing variations.

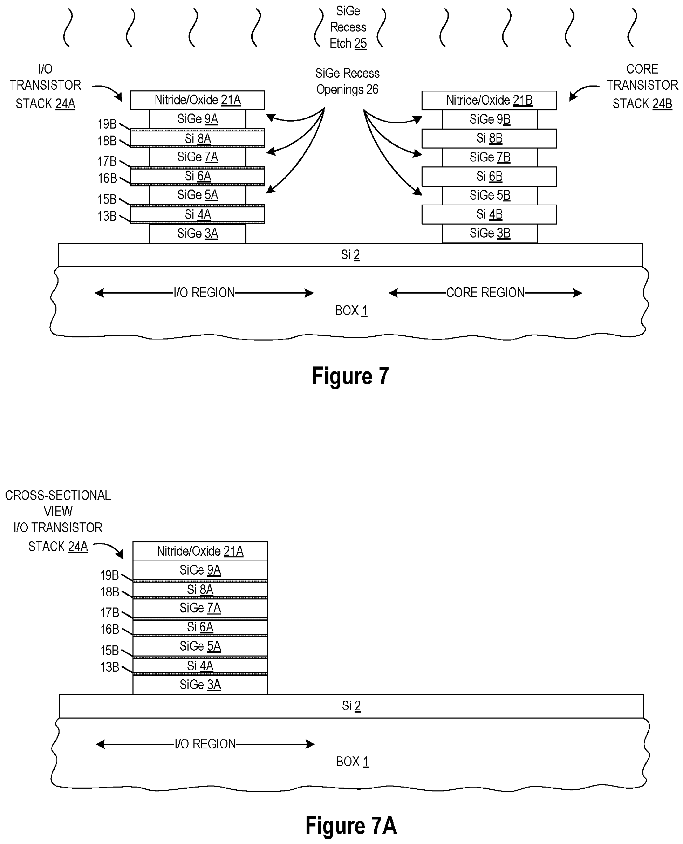

Figures 7-7A illustrate processing of the semiconductor structure subsequent to Figure 6 after applying a selective SiGe recess etch process 25 to selectively recess exposed SiGe nanosheet layers 3A/B, 5A/B, 7A/B, 9A/B, thereby forming recess openings 26 on the exposed sides of the I/O and core transistor stacks 24A, 24B. In particular, Figure 7 depicts a first cross-sectional perspective of the I/O region and core region along the gate length direction, while Figure 7A depicts the I/O region from a second perpendicular cross-sectional perspective along the gate width direction. At the depicted processing stage, the patterned photoresist (PR) mask 22A, 22B has been removed using any suitable stripping process, followed by application of a selective SiGe recess etch 25 to selectively and isotropically recess the SiGe nanosheet layers 3A/B, 5A/B, 7A/B, 9A/B on the exposed sides of the I/O and core transistor stacks 24A, 24B. While any suitable SiGe etch process may be used, a controlled SiGe recess etch process 25, such as a timed isotropic dry etch, may be used to remove a peripheral portion of each sandwiched stack of SiGe nanosheet layers 3A/B, 5A/B, 7A/B, 9A/B from the exposed exterior sides of the I/O and core transistor stacks 24A, 24B. For example, a dry etch process may isotropically etch the SiGe nanosheet layers selective to the Si nanosheet layers, such as by employing isotropic plasma etching process to selectively recess the SiGe layers as described in M. D. Henry et al., "Isotropic Plasma Etching of Ge, Si and SiNx Films," Journal of Vacuum Science and Technology, vol. 34, Issue 5 (Aug. 31, 2016) (https://www.osti.gov/servlets/purl/1323884). Alternatively, a wet etch process may isotropically etch the SiGe nanosheet layers selective to the Si nanosheet layers and any oxide layers 13B, 15B, 16B-19B, such as by employing a wet etch chemistry of HF, hydrogen peroxide, and acetic acid as described in B. Holländer et al, "Wet Chemical Etching of Si, Si1-xGex, and Ge in HF:H2O2:CH3COOH," Journal of The Electrochemical Society, Vol. 157, No, 6, pp. H643-H646 (April 23, 2010) (https://www.researchgate.net/profile/Dan-Buca/publication/235942380_Wet_Chemical_Etching_of_Si_Si1-xGex_and_Ge_in_HFH2O2CH3COOH/links/55b7a09b08aed621de047364/Wet-Chemical-Etching-of-Si-Si1-xGex-and-Ge-in-HFH2O2CH3COOH.pdf). At the conclusion of the SiGe etching process 25, the remnant SiGe nanosheet layer portions 3A/B, 5A/B, 7A/B, 9A/B of the I/O and core transistor stacks 24A, 24B remain where the recess openings 26 have not been formed. As will be appreciated, the etched sidewall edges of the remnant SiGe nanosheet layer portions 3A/B, 5A/B, 7A/B, 9A/B may have a substantially vertical or slightly curved profile resulting from the selective SiGe recess etch 25.

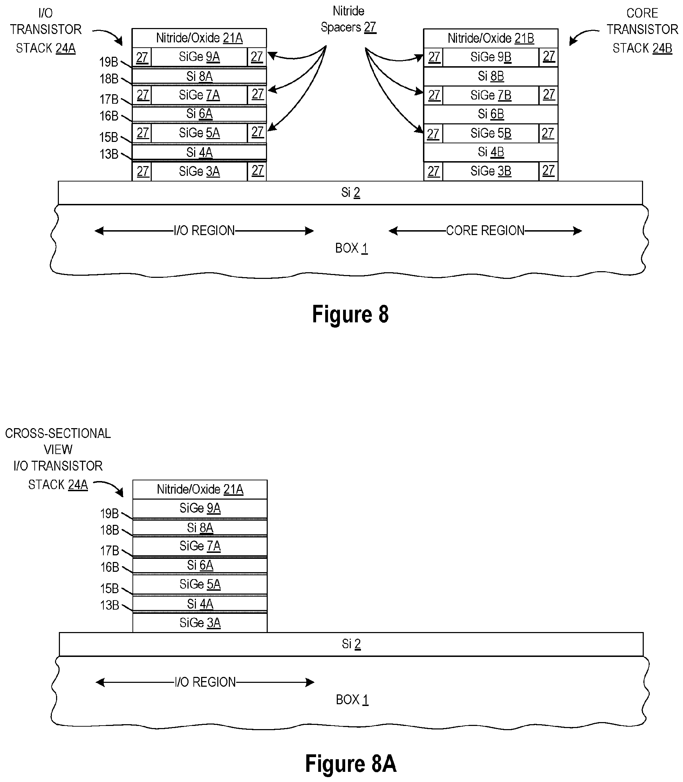

Figures 8-8A illustrate processing of the semiconductor structure subsequent to Figures 7-7A after forming inner nitride spacers 27 to fill the recess openings 26 on the exposed sides of the I/O and core transistor stacks 24A, 24B. In particular, Figure 8 depicts a first cross-sectional perspective of the I/O region and core region along the gate length direction, while Figure 8A depicts the I/O region from a second perpendicular cross-sectional perspective along the gate width direction. While any suitable spacer formation sequence may be used, the inner nitride spacers 27 may be formed by depositing one or more nitride layers over the semiconductor structure, and then applying an isotropic etch process to remove the nitride layer(s) from the top and sides of the I/O and core transistor stacks 24A, 24B but leaving remnant nitride spacers 27 in the recess openings 26. For example, an inner nitride layer may be deposited over the semiconductor structure to a predetermined thickness that is sufficient to cover at least the I/O and core transistor stacks 24A, 24B and fill the recess openings 26 on the exposed sides thereof. By applying an isotropic nitride etch process (e.g., RIE) to remove the inner nitride layer from the top and sides of the I/O and core transistor stacks 24A, 24B, the unetched nitride layer(s) form inner nitride spacers 27 on the I/O and core transistor stacks 24A, 24B. As will be appreciated, the material used to form the inner nitride spacers 27 should have a different stoichiometry from the materials used to form any protective nitride layer 21A/B so that any protective nitride layer 21A/B is only slightly affected or removed during the formation of the inner nitride spacers 27. As will be appreciated, the etched sidewall edges of the inner nitride spacers 27 may have a substantially vertical or slightly curved profile resulting from the applied isotropic nitride etch process.

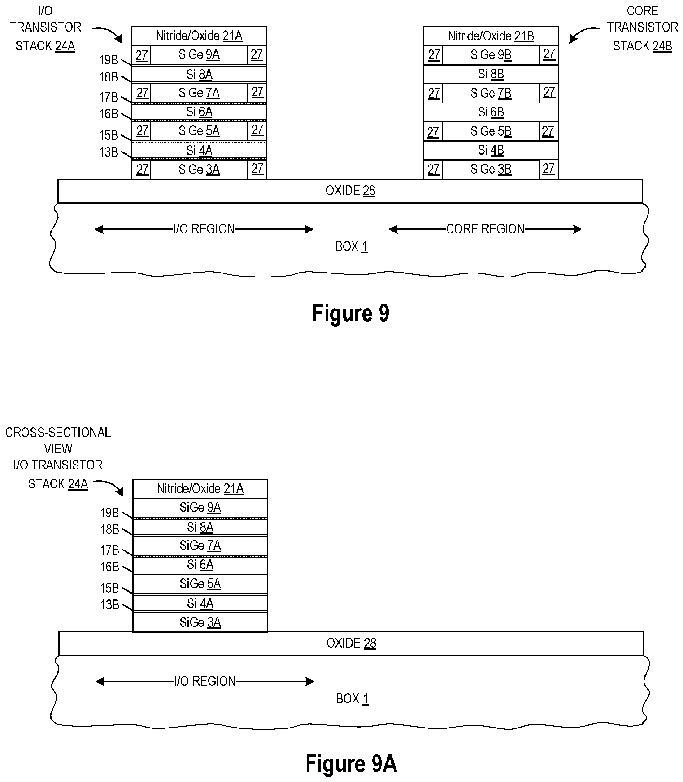

Figures 9-9A illustrate processing of the semiconductor structure subsequent to Figures 8-8A after forming a replacement oxide fill layer 28 to replace at least part of the Si nanosheet layer 2 in accordance with selected embodiments of the present disclosure. In particular, Figure 9 depicts a first cross-sectional perspective of the I/O region and core region along the gate length direction, while Figure 9A depicts the I/O region from a second perpendicular cross-sectional perspective along the gate width direction. While any suitable process may be used to form the replacement oxide fill layer 28, in selected embodiments, a suitable lateral silicon etch (e.g., isotropic silicon wet etch) is applied to remove the bottom Si nanosheet layer 2 except for stack ends in the width dimension (e.g., perpendicular to the gate length dimension) that remain to support the I/O and core transistor stacks 24A, 24B. The process may include depositing and etching oxide spacers (not shown) to protect the sidewalls of the I/O and core transistor stacks 24A, 24B, followed by forming a patterned resist etch mask (not shown) which protects the ends of the Si/SiGe stacks (in z-direction) in the I/O and core transistor stacks 24A, 24B, but exposes the bottom Si nanosheet layer 2. After applying an isotropic etch process to etch at least a portion of the bottom Si nanosheet layer 2 while leaving the Si nanosheet layer 2 underneath ends of Si/SiGe stacks for structural support, the resulting opening is filled with one or more oxide layers to form the replacement oxide fill layer 28. For example, one or more conformal CVD oxide layers may be formed to fill the opening and form the replacement oxide fill layer 28. Subsequently, the oxide spacers are removed from the Si/SiGe stacks, and the remnant ends of the bottom Si nanosheet layer 2 can be etched away in subsequent processing during the active photo/etch processing.

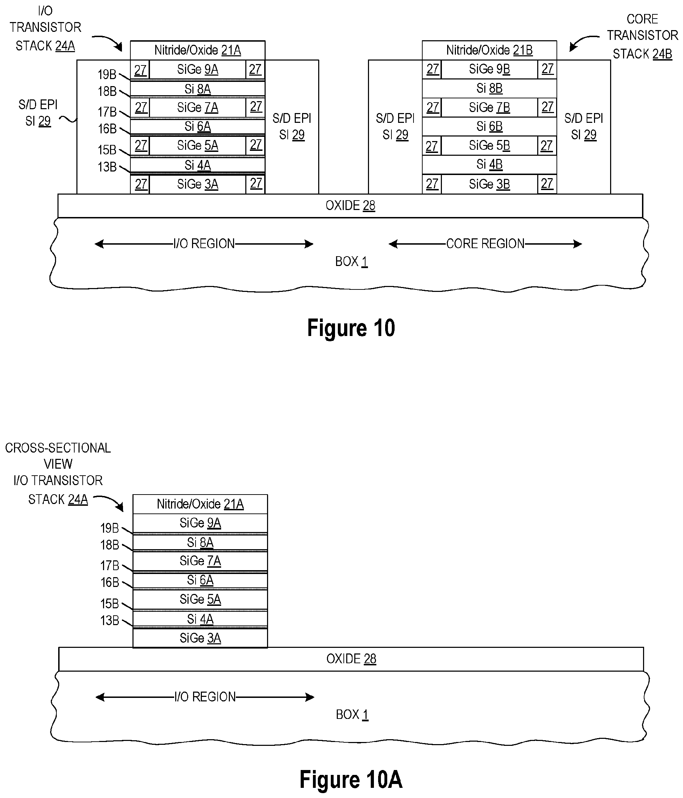

Figures 10-10A illustrate processing of the semiconductor structure subsequent to Figures 9-9A after epitaxially growing and doping or implanting source/drain regions 29 adjacent to the I/O and core transistor stacks 24A, 24B. In particular, Figure 10 depicts a first cross-sectional perspective of the I/O region and core region along the gate length direction, while Figure 10A depicts the I/O region from a second perpendicular cross-sectional perspective along the gate width direction. While any suitable source/drain fabrication sequence may be used, the source/drain regions 29 may be formed by using the exposed portion of the Si nanosheet layers 4A/B, 6A/B, 8A/B to epitaxially grow or deposit a semiconductor layer (e.g., silicon) in the regions adjacent to the I/O and core transistor stacks 24A, 24B. As will be appreciated, the epitaxial silicon deposition or growth process forms the epitaxial source/drain regions 27 from the exposed Si nanosheet layers 4A/B, 6A/B, 8A/B. At this point, the epitaxial source/drain regions 29 can be doped using any suitable doping technique. For example, the epitaxial source/drain regions may be in-situ doped during the epi process, such as by doping the epitaxially grown source/drain features with boron, arsenic and/or phosphorus to form doped epitaxial source/drain regions 29. In some embodiments, the source/drain features are not in-situ doped, and instead an implantation process is performed to dope the epitaxial source/drain regions 29. In some embodiments, after formation of the source/drain regions 29, an epi anneal process may be performed to promote formation of crystalline structures in the epitaxial source/drain regions 29, such as by applying a high thermal budget process. At a later stage in the process flow, one or more etch or polish steps may be applied to planarize the top surface of the epitaxial source/drain regions 29.

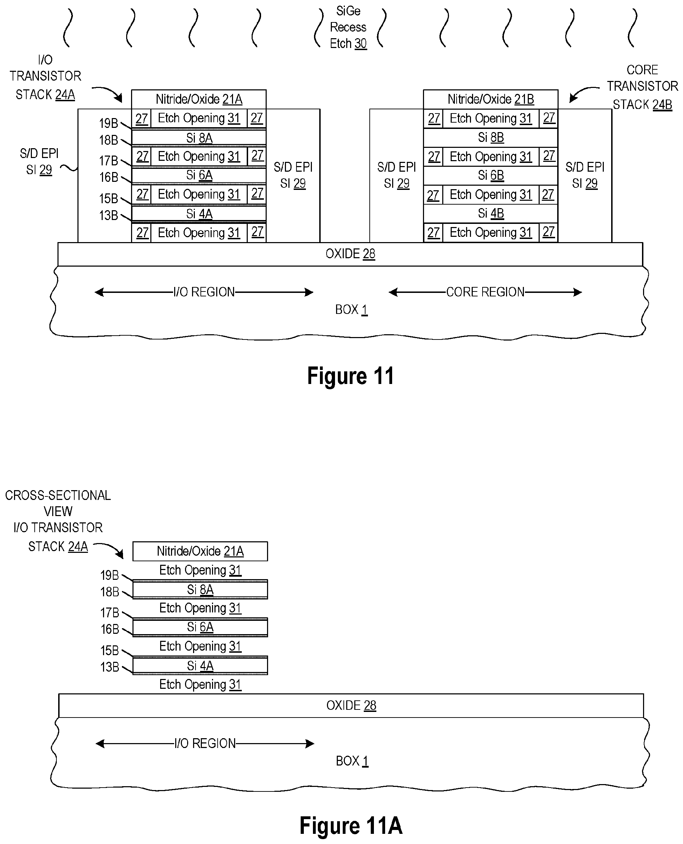

Figures 11-11A illustrate processing of the semiconductor structure subsequent to Figures 10-10A after applying a selective SiGe recess etch process 30 to selectively etch the SiGe nanosheet layers 3A/B, 5A/B, 7A/B, 9A/B from the I/O and core transistor stacks 24A, 24B, thereby forming gate electrode etch openings 31 in the I/O and core transistor stacks 24A, 24B. In particular, Figure 11 depicts a first cross-sectional perspective of the I/O region and core region along the gate length direction, while Figure 11A depicts the I/O region from a second perpendicular cross-sectional perspective along the gate width direction. While any suitable SiGe etch process 30 may be used, a controlled SiGe recess etch process, such as a timed isotropic dry etch, may be used to remove the SiGe nanosheet layers 3A/B, 5A/B, 7A/B, 9A/B from the I/O and core transistor stacks 24A, 24B. At the conclusion of the SiGe etching process 30, the remnant SiGe nanosheet layers of the I/O and core transistor stacks 24A, 24B are replaced by gate openings 31 where the gate electrodes for the nanosheet transistors will be formed in the I/O and core transistor stacks 24A, 24B.

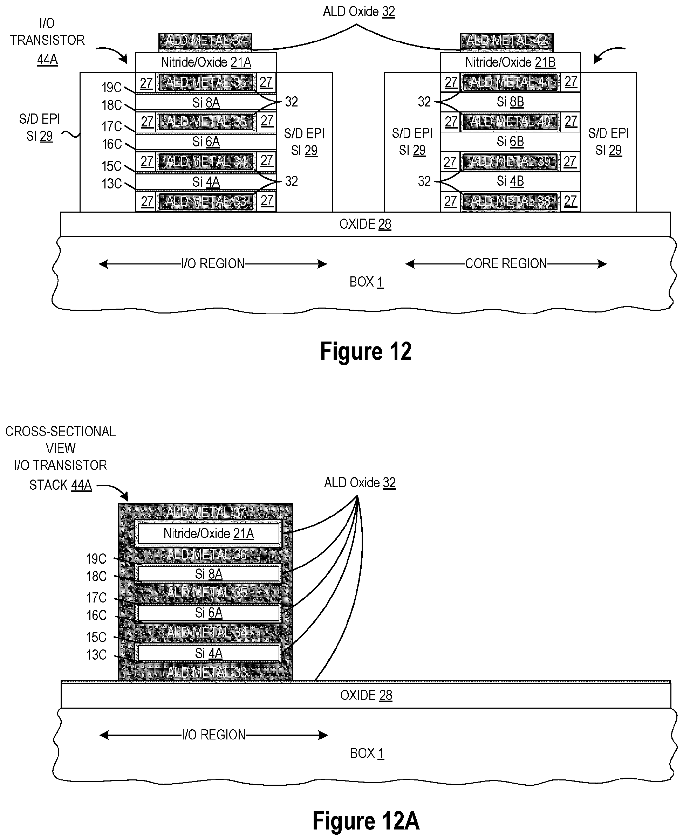

Figures 12-12A illustrate processing of the semiconductor structure subsequent to Figures 11-11A after a conformal gate dielectric layer 32 and metal gate layer(s) 33-42 are formed in the gate electrode etch openings 31 of the I/O and core transistor stacks 24A, 24B. In particular, Figure 12 depicts a first cross-sectional perspective of the I/O region and core region along the gate length direction, while Figure 12A depicts the I/O region from a second perpendicular cross-sectional perspective along the gate width direction. Though not shown, it will be appreciated that selected processing steps may be applied to thermally oxidize the edges of the Si channels in the width dimension prior to forming the conformal gate dielectric layer 32 and metal gate layer(s) 33-42. For example, a layer of SiON may be deposited over the semiconductor structure to fill the gate electrode etch openings 31, followed by an anisotropic etch step which leaves SiON in the gate electrode etch openings 31 but removes the SiON from the Si channel edges. With the Si channel edges exposed, a thermal oxidation process may be applied to form SiO2 channel edge layers on the exposed edges of the Si channels. Subsequently, the SiON is removed from the gate electrode etch openings 31 by applying an isotropic etch that is selective to the SiO2 channel edge layers and SiN inner spacers 27. After forming SiO2 channel edge layers on the edges of the Si channels, the conformal gate dielectric layer 32 may be formed with an atomic layer deposition (ALD) to conformally deposit an ALD oxide layer 32 to a desired gate dielectric thickness (e.g., 5-50 Angstroms) on the interior surfaces of the gate electrode etch openings 31 without completely filling the gate electrode etch openings 31. In selected embodiments, the ALD oxide deposition process may be implemented by exposing the semiconductor structure to a precursor, evacuating or purging the precursors as well as byproducts from the chamber, exposing the semiconductor structure to reactant species (e.g., oxidants or other reagents), and evacuating or purging the reactants and byproduct molecules from the chamber. As a result, the ALD oxide deposition process offers accurate control of film thickness and composition as well as the ability to achieve excellent uniformity over large areas at relatively low temperatures. In addition to forming gate dielectric layers 32 in gate electrode etch openings 31, the resulting ALD oxide layer 32 forms a substantially conformal layer over the upper surface of the semiconductor structure. After forming the ALD oxide layer 32, one or more conductive gate electrode layers 33-42 are formed as a liner layer to cover the I/O and core transistor stacks 24A, 24B and to fill the gate electrode etch openings 31. In selected embodiments, the conductive gate electrode layer(s) 33-42 are formed with an atomic layer deposition (ALD) process to conformally deposit at least a first ALD metal layer 33-42 on the ALD oxide layers 32 to at least partially fill the remaining gate electrode etch openings 31. In selected embodiments, the ALD metal deposition process may be implemented by exposing the semiconductor structure to a precursor, evacuating or purging the precursors as well as byproducts from the chamber, exposing the semiconductor structure to reactant species (e.g., metals or other reagents), and evacuating or purging the reactants and byproduct molecules from the chamber. In addition to forming gate electrode layers 33-42 in the gate electrode etch openings 31, the ALD metal process forms an ALD metal layer as a substantially conformal layer over the upper surface of the semiconductor structure. After forming the ALD oxide layer 32 and ALD metal layers 33-42, one or more patterned etch processes are applied to remove the ALD oxide layer 32 and ALD metal layers 33-42 from the upper surface and sidewalls of the I/O and core transistor stacks 24A, 24B. While any suitable etch process may be used, the patterned etch processing can include forming a patterned etch mask and applying one or more isotropic etching steps (e.g., RIE) having suitable etch chemistry properties to remove, in sequence, the ALD metal layers 33-42 and surface ALD oxide layer 32 from the surface and sidewalls of the semiconductor structure. The etch processing should leave the I/O and core transistor stacks 24A, 24B in place and covered by the protective nitride/oxide layer(s) 21A, 21B. Again, the sidewalls of the protective nitride/oxide layer(s) 21A, 21B are shown as being substantially vertical, though minor deviations in the sidewall profile may occur at each layer due to etch processing variations. Though not shown, it will be appreciated that additional processing steps may be applied such as forming one or more silicide layers on the exposed source/drain regions 29 to facilitate electrical connection to the epitaxial source/drain regions 29.

At the process stage shown in Figure 12, there is provided an I/O nanosheet transistor 44A having a thick I/O gate oxide and core nanosheet transistor 44B formed on a single die with a single nanosheet process flow. As illustrated, the core transistor 44B includes a first nanosheet transistor including the first silicon channel region 4B under control of a gate electrode 38, 39; a second nanosheet transistor including a second silicon channel region 6B under control of a gate electrode 39, 40; and a third nanosheet transistor including a third silicon channel region 8B under control of a gate electrode 40, 41. Between the gate electrodes 38-41 and the silicon channel regions 4B, 6B, 8B of the core transistor 44B, a gate dielectric layer is formed with the ALD oxide layers 32. In addition, the I/O transistor 44A includes a first nanosheet transistor including the first silicon channel region 4A under control of a gate electrode 33, 34; a second nanosheet transistor including a second silicon channel region 6A under control of a gate electrode 34, 35; and a third nanosheet transistor including a third silicon channel region 8A under control of a gate electrode 35, 36. Between the gate electrodes 33-36 and the silicon channel regions 4A, 6A, 8A of the I/O transistor 44A, a thicker gate dielectric layer is formed with a combination of the ALD oxide layers 32 and implanted/annealed oxide layer 13C, 15C, 16C-19C, as illustrated.

To provide a further improvement in the fabrication of core nanosheet transistors which are integrated with I/O nanosheet transistors having thick gate dielectric layers, reference is now made to Figure 13 which depicts a partial cross-sectional view of a semiconductor structure including stacked Si/SiGe superlattice layers 102-109 which are formed over a buried oxide (BOX) or dielectric layer 101 in accordance with selected embodiments of the present disclosure. As will be appreciated, the stacked Si/SiGe superlattice layers 102-109 and BOX layer 101 may be formed over an underlying substrate (e.g., a bulk silicon substrate, monocrystalline silicon (doped or undoped), or any semiconductor material) using any suitable sequence of processing steps, such as by epitaxially growing a plurality of nanosheet semiconductor layers of alternating silicon (Si) nanosheet layers 102, 104, 106, 108 and silicon germanium (SiGe) nanosheet layers 103, 105, 107, 109 which cover both the I/O and core regions. The relative thicknesses and material components of the individual layers in the stacked Si/SiGe superlattice layers 102-109 can be controlled as desired to achieve the final I/O and core transistors described hereinbelow.

Figure 14 illustrates processing of the semiconductor structure subsequent to Figure 13 after the stacked Si/SiGe superlattice layers 102-109 are patterned and etched to form a core region stack 112 over the core region. While any suitable pattern and etch process may be used, a patterned photoresist (PR) mask 110 may be formed over the stacked Si/SiGe superlattice layers 102-109, alone or in combination with a protective oxide/nitride layer (not shown) by depositing, patterning, etching or developing a photoresist or hard mask layer. With the patterned photoresist mask 110 in place, one or more patterned etch processes 111 are applied to create a core region stack 112 (103A-109A). The patterned etch processing 111 can include using the patterned photoresist mask 110 to perform a sequence of reactive-ion etching (RIE) steps having suitable etch chemistry properties to remove, in sequence, the exposed portions of the underlying layers of the Si/SiGe superlattice 103-109 over the I/O region. As will be appreciated, the sidewalls of the core region stack 112 are substantially vertical, though minor deviations in the sidewall profile may occur at each layer due to etch processing variations.

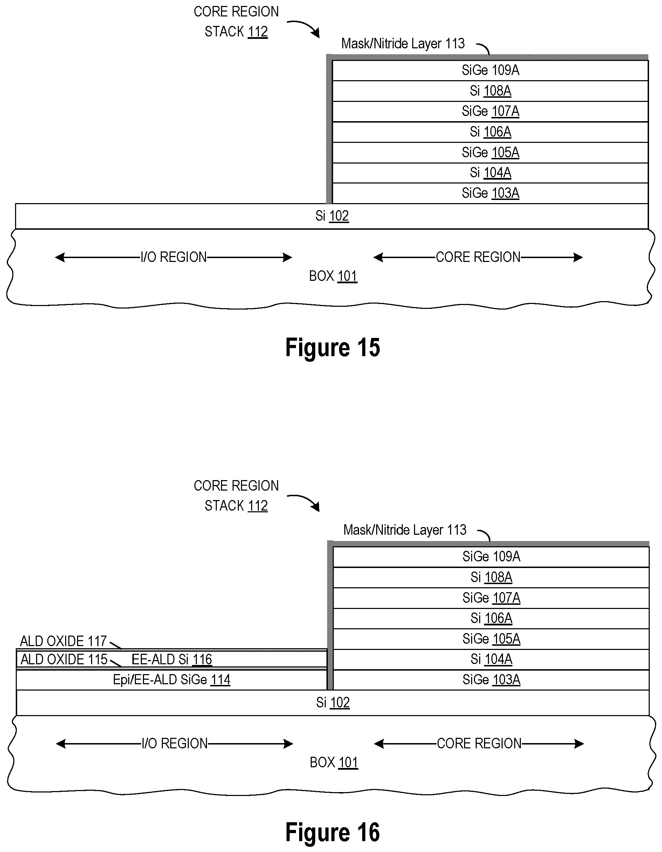

Figure 15 illustrates processing of the semiconductor structure subsequent to Figure 14 after a patterned mask layer 113 is formed to protect the core region stack 112. In selected embodiments, the patterned mask layer 113 is formed over the semiconductor structure as a thin nitride layer using any suitable deposition process, such as CVD, PECVD, PVD, ALD, or any combination(s) of the above to a thickness of approximately 20-200 Angstroms, though a thinner or thicker nitride mask layer may also be used. Subsequently, the thin nitride layer may be patterned and etched to clear the I/O region, such as by depositing, patterning, etching or developing a photoresist or hard mask layer to form a patterned mask (not shown) on the nitride layer 113, and then applying a patterned nitride etch process (e.g., RIE) or other anisotropic etch process with the patterned photoresist mask in place to remove exposed portions of the thin nitride layer 113 from the I/O region while retaining them on the vertical sidewalls of the core region stack 112.

Figure 16 illustrates processing of the semiconductor structure subsequent to Figure 15 after forming a second stack of alternating SiGe and Si nanosheet layers 114, 116 with intervening ALD oxide layers 115, 117 over the silicon nanosheet layer 102 located in the I/O region. As disclosed herein, the first SiGe nanosheet layer 114 may be formed or grown on the silicon nanosheet layer 102 using any suitable deposition or growth process, including but not limited to epitaxial growth/deposition/formation, chemical vapor deposition (CVD), plasma-enhanced chemical vapor deposition (PECVD), physical vapor deposition (PVD), molecular beam epitaxy, sputtering, atomic layer deposition (ALD), electron-enhanced ALD (EE-ALD) or the like. After forming the first SiGe nanosheet layer 114, an ALD oxide layer 115 is formed on the first SiGe nanosheet layer 114 to a predetermined thickness of approximately 5-50 Angstroms, though a thinner or thicker ALD oxide layer 115 may also be used. After forming the ALD oxide layer 115, a Si nanosheet layer 116 is formed on the ALD oxide layer 115 to a thickness of approximately 10-100 Angstroms, though a thinner or thicker Si nanosheet layer 116 may also be used. In selected embodiments, the Si nanosheet layer 116 is formed or grown on the ALD oxide layer 115 using an electron-enhanced ALD (EE-ALD) process, though any suitable thin-film deposition or growth process may be used. After forming the Si nanosheet layer 116, another ALD oxide layer 117 is formed on the Si nanosheet layer 116 to a predetermined thickness.

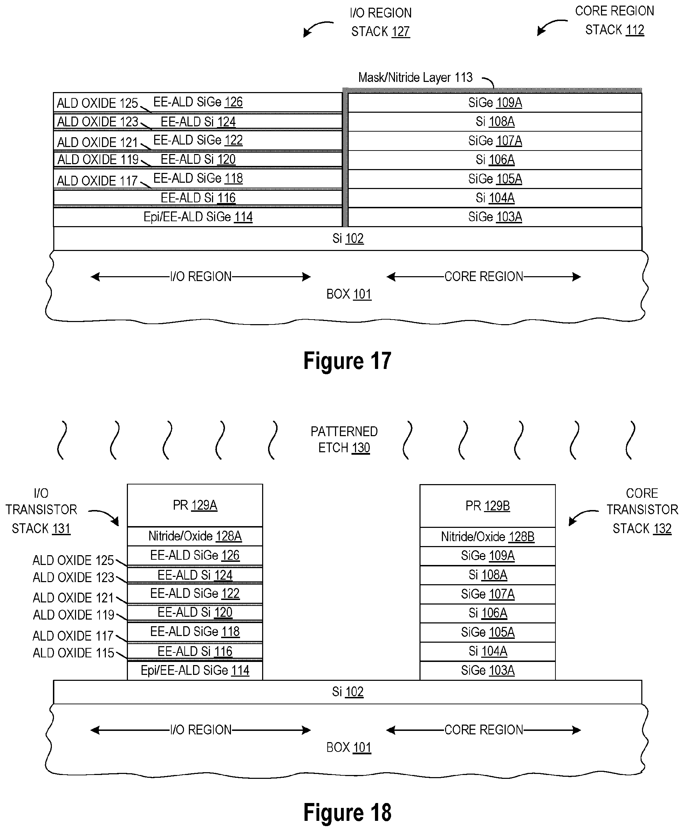

Figure 17 illustrates processing of the semiconductor structure subsequent to Figure 16 after completing the fabrication of the Si/SiGe stack and ALD oxide layers 114-126 on the silicon nanosheet layer 102. As will be appreciated, any suitable sequence of processing steps may be used to form the Si/SiGe stack and ALD oxide layers 114-126, such as by using an EE-ALD process to deposit or grow the SiGe nanosheet layer 118 on the ALD oxide layer 117, using an ALD process to grow the ALD oxide layer 119 on the SiGe nanosheet layer 118, using an EE-ALD process to deposit or grow the Si nanosheet layer 120 on the ALD oxide layer 119, and so on until the Si/SiGe stack and ALD oxide layers 114-126 form an I/O region stack 127 over the I/O region.

As will be appreciated, the I/O region stack 127 can include any number of SiGe nanosheet layers and Si nanosheet layers, but in selected preferred embodiments, there are an equal number of SiGe nanosheet layers in the I/O region stack 127 and the core region stack 112. In addition, there are an equal number of Si nanosheet layers in the I/O region stack 127 and the core region stack 112. In addition, the number of SiGe nanosheet layers and Si nanosheet layers in each stack 112, 127 may be modulated (e.g., increased or decreased) by the number of cycles of epitaxial growth used to form stacks 112, 127. To ensure that the I/O region stack 127 has the same stack height as the core region stack 112, the EE-ALD process parameters are controlled to form the Si nanosheet layers (e.g., 116, 120, 124) in the I/O region to be thinner than the corresponding Si nanosheet layers (e.g., 104A, 106A, 108A) in the core region, thereby enabling the finally-formed I/O and core transistor stacks to have the same stack height which promotes gate photo processing and overall planarity.

Figure 18 illustrates processing of the semiconductor structure subsequent to Figure 17 after a patterned etch process 130 is applied to the I/O region stack 127 and the core region stack 112 to form an I/O transistor stack 131 and core transistor stack 132. In selected embodiments, the patterned etch process 130 may start by stripping the exposed portions of the patterned nitride mask layer 113 from the top of the semiconductor structure. Subsequently, a nitride and/or oxide 128A, 128B may be formed over the semiconductor structure, such as by depositing or otherwise forming a protective oxide and/or nitride layer using CVD, PECVD, PVD, ALD, thermal oxidation, or any combination(s) of the above to a thickness of approximately 20-200 Angstroms, though a thinner or thicker oxide layer may also be used. Subsequently, a patterned photoresist (PR) mask 129A, 129B may be formed over the protective oxide/nitride layer 128A/B by depositing, patterning, etching or developing a photoresist or hard mask layer. With the patterned photoresist mask 129A, 129B in place, one or more etch processes are applied to create an I/O transistor stack 131 (114-126) and a core transistor stack 132 (103A-109A). The etch processing can include using the patterned photoresist mask 129A, 129B to perform a sequence of reactive-ion etching (RIE) steps having suitable etch chemistry properties to remove, in sequence, the exposed portions of the underlying layers. As will be appreciated, the sidewalls of the core and I/O transistor stacks 131, 132 are substantially vertical, though minor deviations in the sidewall profile may occur at each layer due to etch processing variations.

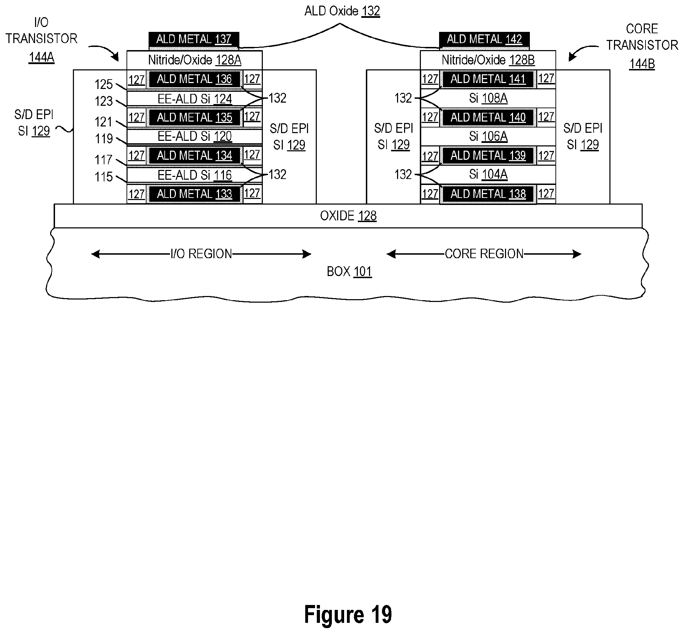

Figure 19 illustrates processing of the semiconductor structure subsequent to Figure 18 after processing the I/O transistor stack 131 and core transistor stack 132 to form an I/O transistor 144A and core transistor 144B, such as by using the fabrication processing steps described hereinabove with reference to Figures 7-12. In particular, the exposed sidewalls of the SiGe nanosheet layers 114, 118, 122, 126, 103A, 105A, 107A, 109A may be selectively etched and filled to form inner nitride spacers 127. In addition, the silicon nanosheet layer 102 is selectively etched to form openings below the I/O transistor stack 131 and core transistor stack 132 that are filled with the replacement oxide fill layer 128. In addition, source/drain regions 129 are epitaxially grown adjacent to the I/O and core transistor stacks where they are doped or implanted, etched and/or polished. In addition, the remnant SiGe nanosheet layers 114, 118, 122, 126, 103A, 105A, 107A, 109A may be selectively etched to form gate electrode etch openings in the I/O transistor stack 131 and core transistor stack 132 without removing the ALD oxide layers 115, 117, 119, 121, 123, 125. As a preliminary step to forming gate electrodes in the gate electrode etch openings, selected processing steps may be applied to thermally oxidize the edges of the Si channels in the width dimension. For example, SiON layer is deposited to fill gate electrode etch openings, followed by applying an anisotropic etch to expose the edges of the silicon channels while leaving SiON in the gate electrode etch openings. With the silicon channel edges exposed, a thermal oxidation process is applied to form SiO2 on exposed edges of Si channels and then the SiON is selectively etched from gate electrode etch openings by applying an isotropic etch process which is selective to SiO2 and SiN inner spacers. Afterward, an ALD oxide layer 132 is formed as a liner layer in the gate electrode etch openings without completely filling the gate electrode etch openings, followed by forming or depositing one or more ALD metal layers 133-142 in the gate electrode etch openings to form the gate electrodes. In this way, the core transistor 144B includes a plurality of nanosheet transistors in which the silicon channel regions 104A, 106A, 108A are under control of the ALD metal gate electrode 138-141 and ALD gate oxide 132 formed in gate electrode etch openings that are selectively etched from the remnant SiGe nanosheet layers 103A, 105A, 107A, 109A that remain after forming inner nitride spacers 127 in the core transistor 144B. In addition, the I/O transistor 144A includes a plurality of nanosheet transistors in which the silicon channel regions 116, 120, 124 are under control of the ALD metal gate electrode 133-136 and ALD gate oxide 132 formed in gate electrode etch openings that are selectively etched from the remnant SiGe nanosheet layers 114, 118, 122, 126 that remain after forming inner nitride spacers 27 in the I/O transistor 144A. However, since there are also intervening ALD oxide layers 115, 117, 119, 121, 123, 125 formed in the I/O transistor 144A between the gate electrodes 133-136 and the silicon channel regions 116, 120, 124, the I/O transistor 144A has a thicker gate dielectric layer than the core transistor 144B, but also will have the same amount of room for gate formation as the core transistor 144B. As a result, the I/O transistor 144A has the same number of Si nanosheet channel layers as the core transistor 144B. And while the Si nanosheet channel layers 116, 120, 124 in the I/O transistor 144A are thinner than the Si nanosheet channel layers 104A, 106A, 108A in the core transistor 144B, the Si nanosheet channel layers 116, 120, 124 in the I/O transistor 144A have a uniform thickness their entire length with no undercut of the inner nitride spacers 127 which will minimize device performance variation.

While specific implementation details are described herein for integrating the fabrication of I/O nanosheet transistors and core nanosheet transistors with the nanosheet transistor process flow to make dual use of fabrication steps, it will be appreciated that additional or fewer processing steps may be used and/or combined.

Also, it will be appreciated that additional processing steps will be used to complete the fabrication of the I/O transistor 44A, 144A and the core transistor 44B, 144B into functioning devices. As examples, one or more sacrificial oxide formation, stripping, isolation region formation, spacer formation, source/drain implant, heat drive or anneal steps, and polishing steps may be performed, along with conventional backend processing (not depicted) typically including formation of multiple levels of interconnect that are used to connect the transistors in a desired manner to achieve the desired functionality. Thus, the specific sequence of steps used to complete the fabrication of the gate electrodes may vary, depending on the process and/or design requirements.

Turning now to Figure 20, there is illustrated a simplified process flow 200 for integrating the fabrication of I/O and core nanosheet transistors having thicker I/O gate oxide thicknesses in accordance with selected embodiments of the present disclosure. Stated generally, the process includes an initial set of fabrication steps 210 to fabricate a wafer substrate having I/O and core transistor stacks formed with a Si/SiGe superlattice structure of alternating silicon nanosheets and silicon germanium nanosheets, where the I/O Si/SiGe superlattice structure includes an implanted/annealed or atomic layer deposition gate dielectric layer separating adjacent silicon nanosheets and silicon germanium nanosheets. A second set of fabrication steps 220 processes the I/O and core transistor stacks to partially etch exposed SiGe nanosheets and form recess openings in the Si/SiGe superlattice which are filled with inner nitride spacers to define remnant SiGe nanosheets. A third set of fabrication steps 230 forms epitaxial source/drain regions on the sides of the I/O and core transistor stacks. A fourth set of fabrication steps 240 forms gate dielectric and metal gate electrodes in the I/O and core transistor stacks. As will be appreciated, each set of fabrication steps 210, 220, 230, 240 can be implemented in different embodiments using the processing steps disclosed herein or modifications thereto as will be understood by those skilled in the art. However, by way of illustrating selected example embodiments of the present disclosure, each set of fabrication steps 210, 220, 230, 240 is described hereinbelow with an example processing step sequence.

Starting with the initial set of fabrication steps 210, the process 200 may begin at step 211 with a wafer substrate which is processed to form a silicon/silicon germanium (SiGe) superlattice structure over the core and I/O regions which is covered by oxide and/or nitride cover layers. In selected embodiments, the SiGe superlattice structure is formed to have alternating Si and SiGe layers by epitaxially growing alternating layers of Si and SiGe on a silicon substrate layer, with the Si/SiGe superlattice structure covered by depositing an oxide protective layer and/or a protective nitride layer. In the I/O regions, the SiGe superlattice structure may be selectively implanted to form implanted oxygen layers in the top and bottom of each Si layer in the course of fabricating the Si layers in the Si/SiGe superlattice structure. For example, a patterned implant mask may be formed on each Si layer before applying a deep oxygen implantation process to form a deeply implanted oxygen layer at the bottom of the Si layer, and also applying a shallow oxygen implantation process to form a shallow implanted oxygen layer at the top of the Si layer. By applying a high temperature anneal step, the implanted oxygen layers are structurally restructured with an oxide self-assembly effect to form oxide layers at the top and bottom of each Si layer. In other embodiments, the SiGe superlattice structure in the I/O regions may be formed by forming an ALD oxide layer over and under each Si layer in the course of fabricating the Si layers in the Si/SiGe superlattice structure.

The initial set of fabrication steps 210 may also include a transistor gate length photo and etch step 212 where the Si/SiGe superlattice structure is processed with a gate length photo/etch process to form one or more core transistor stack(s) and I/O transistor stack(s). For example, a photoresist layer may be deposited, patterned, etched and developed to form a patterned photoresist or hard mask layer on the protective oxide or nitride layer. With the patterned photoresist/hard mask layer in place, the processing at step 212 may include applying one or more etch processes to create the separately delineated core transistor stack(s) and I/O transistor stack(s). The etch processing can include a sequence of reactive-ion etching (RIE) steps having suitable etch chemistry properties to sequentially remove exposed portions of the protective oxide or nitride and underlying layers of the Si/SiGe superlattice structure.

To process the core transistor stack(s) and I/O transistor stack(s) to form and protect remnant SiGe layers having a first gate length dimension, the disclosed second set of fabrication steps 220 may include a selective recess etch step 221 where the SiGe layers at the exposed sides of the core transistor stack(s) and I/O transistor stack(s) are selectively etched to form SiGe recess openings. For example, a controlled etch process, such as a timed isotropic dry etch, may be applied to selectively recess the SiGe layers exposed at the sides of the core transistor stack(s) and I/O transistor stack(s), thereby forming remnant SiGe layers that are defined between the SiGe recess openings.

The second set of fabrication steps 220 may also include a nitride spacer formation step 222 for protecting the remnant SiGe layers in the core transistor stack(s) and I/O transistor stack(s) from subsequent processing. For example, a first inner nitride layer may be deposited over the semiconductor structure, and then patterned and isotropically etched to leave the inner nitride layer only in the SiGe recess openings of the core transistor stack(s) and I/O transistor stack(s).

To form epitaxial source/drain regions on the sides of the core transistor stack(s) and I/O transistor stack(s), the third set of fabrication steps 230 may include one or more epitaxial source/drain formation step(s) 231 for selectively forming and doping or implanting the epitaxial source/drain regions on the sides of the core transistor stack(s) and I/O transistor stack(s). For example, an epitaxial silicon deposition or growth process may be used to selectively form epitaxial source/drain regions to surround the core transistor stack(s) and I/O transistor stack(s) up to the height of the core transistor stack(s) and I/O transistor stack(s), either by a controlled epitaxial growth process or an overgrowth process coupled with epitaxial silicon etch and/or polish steps. Depending on the type of nanosheet transistor formed in the core transistor stack(s) and I/O transistor stack(s), the epitaxial source/drain regions may be doped or implanted with N-type or P-type impurities. In addition, the formation of doped epitaxial source/drain regions may include one or more anneal processes to promote formation of crystalline structures in the epitaxial source/drain regions and/or may include one or more etch or polish steps to planarize the top surface of the epitaxial source/drain regions.

To process the remnant SiGe layers to form gate electrodes in core transistor stack(s) and I/O transistor stack(s), the fourth set of fabrication steps 240 may include one or more selective SiGe etch steps 241 for selectively removing the remnant SiGe layers from the core transistor stack(s) and I/O transistor stack(s) to form gate electrode etch openings. For example, the core transistor stack(s) and I/O transistor stack(s) may be patterned with an active photo/etch process to access the underlying remnant SiGe layers, such as by depositing, patterning, etching and/or developing a photoresist layer to form a patterned photoresist or hard mask layer with mask openings positioned to access the underlying remnant SiGe layers. With the patterned photoresist/hard mask layer in place, the processing at step 241 may include applying one or more etch processes to access the underlying remnant SiGe layers in the core transistor stack(s) and I/O transistor stack(s). The etch process can include a sequence of reactive-ion etching (RIE) steps having suitable etch chemistry properties to sequentially remove exposed portions of the underlying layers, but without removing the implanted/annealed oxide layers or ALD oxide layers in the I/O region.

The fourth set of fabrication steps 240 may also include a gate stack formation step 242 for forming gate stacks in the gate electrode etch openings. As a preliminary step to forming gate stacks in the gate electrode etch openings, selected processing steps may be applied to thermally oxidize the edges of the Si channels in the width dimension. For example, SiON layer is deposited to fill gate electrode etch openings, followed by applying an anisotropic etch to expose the edges of the silicon channels while leaving SiON in the gate electrode etch openings. With the silicon channel edges exposed, a thermal oxidation process is applied to form SiO2 on exposed edges of Si channels and then the SiON is selectively etched from gate electrode etch openings by applying an isotropic etch process which is selective to SiO2 and SiN inner spacers. Afterward, the gate stacks or electrodes may be formed by depositing a first ALD oxide layer to form a conformal thin dielectric layer in the gate electrode etch openings of the core transistor stack(s) and I/O transistor stack(s), and then depositing a first ALD metal layer to form gate electrodes by filling the gate electrode etch openings of the core transistor stack(s) and I/O transistor stack(s).

At this process stage, the front end of line processing of the nanosheet transistors in the core transistor stack(s) and I/O transistor stack(s) is complete except for any silicidation, though additional processing steps can be performed to form additional circuit elements, such as sidewall capacitors and/or non-volatile memory cells.

The disclosed fourth set of fabrication steps 240 may use one or more steps 243 to form silicide layers along with any required back-end-of-line processing to form contacts. For example, the silicide formation sequence of step 243 may start with one or more initial silicide formation steps to form silicide layers on exposed source/drain regions to facilitate electrical connection thereto.

A semiconductor device and fabrication method are described for integrating I/O and core nanosheet transistors in a single nanosheet process flow by processing a stack of alternating first and second semiconductor structures formed on a substrate, where the first semiconductor structures located over a I/O thick oxide transistor region include a planar semiconductor channel layer sandwiched between upper and lower dielectric layers, and where the alternating first and second semiconductor structures are processed to form gate-all-around electrodes in a core transistor stack that are connected over a relatively thinner gate dielectric layer to control one or more first planar semiconductor channel layers in the core transistor stack, and to form gate-all-around electrodes in an I/O transistor stack that are connected over a relatively thicker gate dielectric layer to control one or more second planar semiconductor channel layers in the I/O transistor stack.

By now it should be appreciated that there has been provided a method for forming a semiconductor device which integrates the fabrication of input/output (I/O) and core nanosheet transistors. In the disclosed method, a stack of alternating first and second semiconductor structures is provided on a substrate having an input/output (I/O) thick oxide transistor region and a core thin oxide transistor region, where each of the first semiconductor structures located over the I/O thick oxide transistor region includes a planar semiconductor channel layer sandwiched between an upper dielectric layer and a lower dielectric layer. In selected embodiments, the stack of alternating first and second semiconductor structures is provided as alternating silicon nanosheet and silicon germanium nanosheet layers over the I/O thick oxide transistor region and core thin oxide transistor region, where each of the first silicon nanosheet layers located over the I/O thick oxide transistor region is a planar silicon channel layer sandwiched between an upper oxide layer and a lower oxide layer. In other embodiments, each first semiconductor structure includes a silicon nanosheet layer sandwiched between an upper oxide layer and a lower oxide layer, where the upper and lower oxide layers are each formed with annealed implanted oxygen. In other embodiments, each first semiconductor structure includes a silicon nanosheet layer sandwiched between an upper ALD oxide layer and a lower ALD oxide layer. In such embodiments, the step of providing the stack of alternating first and second semiconductor structures includes providing alternating electron-enhanced ALD silicon and electron-enhanced ALD silicon germanium layers over the I/O thick oxide transistor region, where each of the electron-enhanced ALD silicon layers over the I/O thick oxide transistor region is sandwiched between an upper ALD oxide layer and a lower ALD oxide layer. The disclosed method also includes selectively etching the stack of alternating first and second semiconductor structures to form an I/O transistor stack and a core transistor stack on the substrate. In addition, the disclosed method includes processing the I/O transistor stack and a core transistor stack with a shared sequence of fabrication steps to form gate-all-around electrodes between the first semiconductor structures in the input/output transistor stack and the core transistor stack. As disclosed, each gate-all-around electrode formed in the core transistor stack is connected over a first, relatively thinner gate dielectric layer to control one or more first planar semiconductor channel layers in the core transistor stack, and each gate-all-around electrode formed in the input/output transistor stack is connected over a second, relatively thicker gate dielectric layer to control one or more second planar semiconductor channel layers in the I/O transistor stack. In selected embodiments, the input/output transistor stack and the core transistor stack have substantially the same stack height. In other selected embodiments, the one or more first planar semiconductor channel layers in the core transistor stack equals the one or more second planar semiconductor channel layers in the I/O transistor stack.

In another form, there is provided a method for fabricating a semiconductor device which integrates I/O nanosheet transistors with core nanosheet transistors in a single nanosheet process flow. In the disclosed fabrication method, a stack of alternating first and second nanosheet structures is provided on a substrate having an input/output (I/O) transistor region and a core transistor region, where each of the first nanosheet structures located over the I/O transistor region includes a planar semiconductor channel layer sandwiched between an upper dielectric layer and a lower dielectric layer. In selected embodiments, the first nanosheet structure includes a planar silicon nanosheet layer sandwiched between an upper oxide layer and a lower oxide layer, and the second nanosheet structure includes a planar silicon germanium nanosheet layer. In such embodiments, the upper and lower oxide layers may each be formed with annealed implanted oxygen. In other such embodiments, the upper and lower oxide layers may each be formed with an atomic layer deposition (ALD) process. In such embodiments, the stack of alternating first and second nanosheet structures may be provided by forming alternating electron-enhanced ALD silicon and electron-enhanced ALD silicon germanium layers over the I/O transistor region, where each of the electron-enhanced ALD silicon layers over the I/O transistor region is sandwiched between an upper ALD oxide layer and a lower ALD oxide layer. In selected embodiments, the stack of alternating first and second nanosheet structures is provided by forming the second nanosheet structure over the substrate to cover the I/O transistor region; epitaxially growing the planar semiconductor channel layer from the second nanosheet structure to cover the I/O transistor region; selectively implanting the lower dielectric layer into a bottom portion of the planar semiconductor channel layer; and selectively implanting the upper dielectric layer into an upper portion of the planar semiconductor channel layer. In other selected embodiments, the stack of alternating first and second nanosheet structures is provided by forming the second nanosheet structure over the substrate with a layer of electron-enhanced ALD silicon germanium to cover the I/O transistor region; forming the lower dielectric layer with atomic layer deposition oxide on the layer of electron-enhanced ALD silicon germanium to cover the I/O transistor region; forming the planar semiconductor channel layer over the substrate with a layer of electron-enhanced ALD silicon to cover the I/O transistor region; and forming the upper dielectric layer with atomic layer deposition oxide on the layer of electron-enhanced ALD silicon to cover the I/O transistor region. The disclosed fabrication method also selectively etches the stack of alternating first and second nanosheet structures to form at least an I/O nanosheet transistor stack over the I/O transistor region of the substrate. In addition, the disclosed fabrication method processes the I/O nanosheet transistor stack to form conductive terminal structures adjacent to the I/O nanosheet transistor stack and to form a gate-all-around electrode around at least three sides of each first nanosheet structure in the I/O nanosheet transistor stack which are connected between the conductive terminal structures formed on opposite sides of the patterned nanosheet stack. As formed, each gate-all-around electrode formed in the I/O nanosheet transistor stack is connected over a gate dielectric layer and the upper dielectric layer and lower dielectric layer to control the planar semiconductor channel layer in the I/O nanosheet transistor stack. In selected embodiments, the I/O nanosheet transistor stack is processed by forming one or more dielectric layers on peripheral sides of the I/O nanosheet transistor stack which replace peripheral portions of each second nanosheet structure in the I/O nanosheet transistor stack, thereby leaving remnant second nanosheet structures in the I/O nanosheet transistor stack; forming the conductive terminal structures with epitaxial semiconductor structures adjacent to the I/O nanosheet transistor stack; and selectively processing the I/O nanosheet transistor stack to form gate-all-around electrodes which replace the remnant second nanosheet structures in the I/O nanosheet transistor stack.

In yet another form, there is provided a semiconductor device and associated method of fabrication. As disclosed, the semiconductor device includes a substrate, an I/O transistor stack formed on top of the substrate, and a core transistor stack formed on top of the substrate . As formed, the I/O transistor stack includes a first transistor channel structure with a first plurality of planar semiconductor layers separated from one another in a vertical dimension extending from the substrate, and a first control electrode stack formed with a first gate conductor layer, a first gate dielectric layer, and an additional second gate dielectric layer at least partially surrounding the first plurality of planar semiconductor layers to control current flow through the first transistor channel structure. In addition, the core transistor stack includes a second transistor channel structure formed with a second plurality of planar semiconductor layers separated from one another in a vertical dimension extending from the substrate, and a second control electrode stack comprising a second gate conductor layer and a second gate dielectric layer at least partially surrounding the second plurality of planar semiconductor layers to control current flow through the second transistor channel structure. As formed, the first gate dielectric layer and additional second gate dielectric layer have a combined thickness measure that is greater than a thickness measure for the second gate dielectric layer. In selected embodiments, the I/O transistor stack and the core transistor stack have substantially the same stack height, and the first plurality of planar semiconductor layers and the second plurality of planar semiconductor layers have an equal number of semiconductor layers. In selected embodiments, the additional second gate dielectric layer is formed with annealed implanted oxygen. In other selected embodiments, the first plurality of planar semiconductor layers and the second plurality of planar semiconductor layers are each formed with electron-enhanced ALD silicon, and the additional second gate dielectric layer is formed with atomic layer deposition oxide.

Although the described exemplary embodiments disclosed herein are directed to various semiconductor device structures and methods for making same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. For example, the depicted I/O and core nanosheet transistor structures may be formed with different processing steps that can be combined and integrated with other device fabrication steps, and can utilize Si/SiGe superlattice structures having different numbers of SiGe and Si layers. Also, the various silicon-based constituent layers may be formed with different conductive materials than those disclosed. In addition, the epitaxial sources and drains may be p-type or n-type, depending on whether forming either p-type or n-type semiconductor devices. Moreover, the thickness of the described layers may deviate from the disclosed thickness values. Accordingly, the foregoing description is not intended to limit the invention to the particular form set forth, but on the contrary, is intended to cover such alternatives, modifications and equivalents as may be included within the spirit and scope of the invention as defined by the appended claims so that those skilled in the art should understand that they can make various changes, substitutions and alterations without departing from the spirit and scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for forming a semiconductor device comprising:
providing a stack of alternating first and second semiconductor structures on a substrate having an input/output (I/O) thick oxide transistor region and a core thin oxide transistor region, where each of the first semiconductor structures located over the I/O thick oxide transistor region comprises a planar semiconductor channel layer sandwiched between an upper dielectric layer and a lower dielectric layer;
selectively etching the stack of alternating first and second semiconductor structures to form an I/O transistor stack and a core transistor stack on the substrate; and
processing the I/O transistor stack and a core transistor stack with a shared sequence of fabrication steps to form gate-all-around electrodes between the first semiconductor structures in the input/output transistor stack and the core transistor stack,
where each gate-all-around electrode formed in the core transistor stack is connected over a first, relatively thinner gate dielectric layer to control one or more first planar semiconductor channel layers in the core transistor stack, and
where each gate-all-around electrode formed in the input/output transistor stack is connected over a second, relatively thicker gate dielectric layer which includes the upper dielectric layer or the lower dielectric layer to control one or more second planar semiconductor channel layers in the I/O transistor stack.

2. The method of claim 1, where providing the stack of alternating first and second semiconductor structures comprises providing alternating silicon nanosheet and silicon germanium nanosheet layers over the I/O thick oxide transistor region and core thin oxide transistor region, where each of the first silicon nanosheet layers located over the I/O thick oxide transistor region is a planar silicon channel layer sandwiched between an upper oxide layer and a lower oxide layer.

3. The method of claim 1 or 2, where each first semiconductor structure comprises a silicon nanosheet layer sandwiched between an upper oxide layer and a lower oxide layer, where the upper and lower oxide layers are each formed with annealed implanted oxygen.

4. The method of any preceding claim, where each first semiconductor structure comprises a silicon nanosheet layer sandwiched between an upper ALD oxide layer and a lower ALD oxide layer.

5. The method of claim 4, where providing the stack of alternating first and second semiconductor structures comprises providing alternating electron-enhanced ALD silicon and electron-enhanced ALD silicon germanium layers over the I/O thick oxide transistor region, where each of the electron-enhanced ALD silicon layers over the I/O thick oxide transistor region is sandwiched between an upper ALD oxide layer and a lower ALD oxide layer.

6. The method of any preceding claim, where the input/output transistor stack and the core transistor stack have substantially the same stack height.

7. The method of any preceding claim, where the one or more first planar semiconductor channel layers in the core transistor stack equals the one or more second planar semiconductor channel layers in the I/O transistor stack.

8. The method of any preceding claim, where the first, relatively thinner gate dielectric layer in the core transistor stack is formed with a first ALD oxide layer, and where the second, relatively thicker gate dielectric layer in the I/O transistor stack is formed with a second ALD oxide layer and the upper dielectric layer or the lower dielectric layer.

9. A semiconductor device comprising:
a substrate;
an input/output (I/O) transistor stack formed on top of the substrate, the first transistor stack comprising:
a first transistor channel structure with a first plurality of planar semiconductor layers separated from one another in a vertical dimension extending from the substrate, and
a first control electrode stack comprising a first gate conductor layer, a first gate dielectric layer, and an additional second gate dielectric layer at least partially surrounding the first plurality of planar semiconductor layers to control current flow through the first transistor channel structure; and
a core transistor stack formed on top of the substrate, the second transistor stack comprising:
a second transistor channel structure formed with a second plurality of planar semiconductor layers separated from one another in a vertical dimension extending from the substrate, and
a second control electrode stack comprising a second gate conductor layer and a second gate dielectric layer at least partially surrounding the second plurality of planar semiconductor layers to control current flow through the second transistor channel structure,
where the first gate dielectric layer and additional second gate dielectric layer have a combined thickness measure that is greater than a thickness measure for the second gate dielectric layer.

10. The semiconductor device of claim 9, where the I/O transistor stack and the core transistor stack have substantially the same stack height, and where the first plurality of planar semiconductor layers and the second plurality of planar semiconductor layers have an equal number of semiconductor layers.

11. The semiconductor device of claim 9 or 10, where the additional second gate dielectric layer comprises annealed implanted oxygen.

12. The semiconductor device of any of claims 9 to 11, where the first plurality of planar semiconductor layers and the second plurality of planar semiconductor layers each comprise electron-enhanced ALD silicon, and where the additional second gate dielectric layer comprises atomic layer deposition oxide.
